(19) Europäisches Patentamt
European Patent Office
Office européen des brevets

(11) **EP 4 492 073 A1**

(12) **EUROPEAN PATENT APPLICATION**

(43) Date of publication:
**15.01.2025   Bulletin 2025/03**

(21) Application number: **23184969.6**

(22) Date of filing: **12.07.2023**

(51) International Patent Classification (IPC):
***G01R 31/392*** (2019.01)      ***H01G 4/33*** (2006.01)

(52) Cooperative Patent Classification (CPC):
**H01G 4/33;** G01R 31/392; H01M 10/4285

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **ABB SCHWEIZ AG**
**5400 Baden (CH)**

(72) Inventors:
• **PRIVITERA, Lorenzo**
**5400 Baden (CH)**

• **HENCKEN, Kai**
**79539 Lörrach (DE)**
• **SCHLOTTIG, Gerd**
**8142 Uitikon Waldegg (CH)**
• **BORRELLI, Elsi-Mari**
**00530 Helsinki (FI)**
• **WYSOCKI, Wojciech**
**31-271 Kraków (PL)**
• **ADAMCZYK, Bartlomiej**
**31-038 Kraków (PL)**

(74) Representative: **Maiwald GmbH**
**Engineering**
**Elisenhof**
**Elisenstrasse 3**
**80335 München (DE)**

(54) **METHOD FOR ESTIMATING A CONSUMED LIFETIME OF AN ENERGY STORAGE DEVICE**

(57)    The invention relates to the field of energy storage devices, particularly for estimating a consumed lifetime of the energy storage device. The method for estimating the consumed lifetime of an energy storage device comprises the steps of:
measuring a time-series of an environmental relative humidity and a related temperature of the energy storage device; and
estimating, based on the time-series and on a moisture diffusion model of the energy storage device, the consumed lifetime of the energy storage device.

**Fig. 1c**

spatial distribution 4   spatial distribution 5   spatial distribution 6

ambient humidity level 3

EP 4 492 073 A1

## Description

Field of the Invention

The invention relates to the field of energy storage devices, particularly for estimating a consumed lifetime of the energy storage device. The invention further relates to a non-transitory computer-readable storage medium, an apparatus, and to a use.

Background

Energy storage devices may have many reasons for decaying and/or for a shortened lifetime. One reason may be humidity that diffuses in the form of moisture into the energy storage device. An end of lifetime may be harmful to devices and/or even to persons, because the internal moisture may even lead to explosions, particularly in cases when the diffused moisture (i.e. water) has been split into oxyhydrogen gas. Due to this risk, the energy storage devices are in at least some cases sorted out before their real end of life, or they may bear the risk of being sorted out too late. Hence, means for estimating a consumed lifetime of the energy storage devices may be useful.

Description

It is an objective of the invention to provide means for estimating a consumed lifetime of the energy storage devices. This objective is achieved by the subject-matter of the independent claims. Further embodiments are evident from the dependent claims and the following description.

One aspect relates to a method for estimating a consumed lifetime of an energy storage device, the method comprising the steps of:

measuring a time-series of an environmental relative humidity and a related temperature of the energy storage device; and
estimating, based on the time-series and on a moisture diffusion model of the energy storage device, the consumed lifetime of the energy storage device.

Estimating the consumed lifetime of the energy storage device may, e.g., be an indicator for predicting a lifetime - or a lifetime end - of the energy storage device and/or for estimating the current health status of the device. For estimating the consumed lifetime of an individual energy storage device, a time-series of an environmental relative humidity and a related temperature of this energy storage device is measured. The humidity measurement itself may be based either on a relative and/or on an absolute humidity of its environment. Hence, means for transforming this into the desired measurement scale may be foreseen. The related temperature of the energy storage device may be measured directly at the energy storage device, in a defined distance from it, preferably close to it, and/or - maybe for some energy storage devices - inside the device. Additionally or as an alternative, the temperature can be calculated based on some measured temperature and a thermal model of the energy storage device and/or its surrounding. For instance, if the measurement of environmental temperature is the only one available, then the inner temperature may be obtained by adding a temperature difference considering ohmic heating. This value may, e.g., be determined by knowing the electrical parameters of the capacitor and measuring the current. If the current measurement is not possible, environmental temperature may be corrected with a term determined by previous knowledge of capacitor's behaviour. In cases when the method is applied to several capacitors in a bank and only one environmental temperature is available, the effect on thermal behaviour for each capacitor's position may be taken into account. The measurements may be conducted on a regular basis (i.e. periodically), continuously, and/or on demand.

In other words, at least some types of energy storage devices, for instance some accumulators or Metallized Film Capacitors (MFC), are known to suffer from the presence of ambient humidity. Some capacitors may be particularly endangered when operated under AC voltage. Generally, as soon as moisture penetrates the casing and reaches the metallized film inside, electrochemical corrosion and/or corona discharges happen, causing a degradation of the film. This, in turn, is reflected in a change in the electrical parameters, e.g., capacity and ohmic part of impedance (ESR). Eventually, the capacitors may undergo catastrophic failure. To prevent this, the method provides means for monitoring their condition and/or predicting their future behavior, particularly estimating their consumed lifetime.

An approach based on measuring directly these electrical parameters as a way to see the development of degradation may be technically difficult to implement and also difficult to interpret. Particularly, those direct measurements may not be appropriate or convenient, because the energy storage device's electrical parameters may show no change during the time moisture has not yet reached the metallic film. After that point, the degradation can be too fast to make any timely prediction, but also an estimation of the remaining lifetime of the capacitor might be difficult to provide, as the further progression of the damage depends on water entering the metallic film.

A way to cope with or at least to mitigate this problem is to make use of humidity measurements. Direct sensing of (total) moisture content uptake in the capacitor via measurements of the mass increase may both be difficult and, moreover, may give no information on the spatial distribution of water inside the capacitor. Measuring environmental humidity is instead easy but needs to be related to consumed life over time. A standard way to link external humidity to consumed life is by using the so-called Peck-Hallberg model, which is often used for electronic devices put inside of electronics packaging, e.g. inside a filled plastics housing. It provides an acceleration factor, which depends only on the ratio between the instantaneous relative humidity and a reference nominal one, as well as the temperature in an Arrhenius form. However, the Peck-Hallberg model is purely empirical and has two main defects:

1) The model is only applicable in the case of constant conditions. Applying it to variable conditions in a normal way, it assumes an instantaneous effect of humidity. Experiments showed however that there is a retardation effect due to the physical barrier that water must cross before reaching the metallic film. As the Peck-Hallberg model is applied in general only in the case of constant environmental conditions, this retardation can be neglected. For varying conditions the model may be insufficient.

2) It implies that the consumed life can only increase in time. High temperature and/or low concentrations of humidity, however, may dry the capacitor by diffusion and release of moisture towards the ambient, which may slow, delay or even halt the degradation process and may also lower an internal moisture concentration. Accordingly, a consumed life should be able to decrease or recover under such conditions.

Hence, the method is based on a physics-inspired model, which is based on temperature and relative humidity measurements to track the moisture diffusing inside an energy storage device, or an MFC, and consequently determine its lifetime. The method described above and/or below can be used to determine the lifetime of a single capacitor or several capacitors in a bank. Therefore, based on the method, which considers the time-series of humidity and temperature and based on a moisture diffusion model of the energy storage device, the consumed lifetime of the energy storage device can be estimated. The moisture diffusion model - or hygroscopic, humidity, water diffusion model - may be based on the amount of water in the energy storage device, computed from the time-series of measurements and the selected model.

The method advantageously no longer needs to rely on standard assumptions in which environment the energy storage device is operated, but take the real environmental situation of each energy storage device as a base for its estimation. This may both prevent a (possibly harmful) risk of damaging - e.g. when the device is kept too long in its system - and to end up the system's life unnecessarily too early. The estimated consumed lifetime may be an indicator for predicting the end of life of the energy storage device and/or for estimating the current health status of the device. The estimated consumed lifetime may be a basis for outputting an alarm, a maintenance request, and/or for requesting and/or for initiating countermeasures, such as, e.g., means for drying the energy storage device, and/or for further proactive and/or reactive measures.

In various embodiments, the moisture diffusion model considers a spatial distribution of moisture inside the energy storage device. So, both the moisture concentration and the spatial distribution of moisture inside the energy storage device are considered in the model.

In various embodiments, the moisture diffusion model considers a diffusion of moisture into and inside the energy storage device.

In various embodiments, the moisture diffusion model considers a temperature inside the energy storage device, and/or the moisture diffusion model estimates the temperature inside the energy storage device. The estimation of the temperature inside the energy storage device may be based, e.g., on a distance to the energy storage device and/or the device's thermal transfer resistance.

In various embodiments, the parameters of the moisture diffusion model are obtained by doing aging tests for specific conditions, e.g. for constant conditions. These data may be used to determine relevant parameters of the model, e.g. in order to be in line or as close as possible to parameters from tests.

In various embodiments, the consumed lifetime is a function of an amount of water present in an inner part of the energy storage device. The function may be based on one or more models of the energy storage device (see below).

In various embodiments, the consumed lifetime and/or the amount of water is stored as one single variable or distribution function. The distribution function may be stored as a kind of array, as a mathematical function, and/or in another form. The model or distribution function may consider the metallic film in the inner part of the energy storage device.

In an embodiment, the distribution function is based on a 3D, 2D or 1D model of the energy storage device, considering 3, 2, or 1 dimension of the device. Wherein the 3D model may be more precise, the 2D, or even 1D model may be easier to apply, leading to a model that requires less computing power for performing the estimation.

For the estimating of the consumed lifetime, a model may be solved that models the diffusion of moisture into and inside the energy storage device. The model may, generally, be in a form of a partial differential equation of the diffusion in a medium, with the potential presence of one or more interfaces. For example, a first interface may be the one to the outside air, the last interface may be the one connected to the region where moisture leads to degradation, e.g. corrosion, corresponding to the energy storage device's body. The boundary condition, that is the flux of moisture into the medium, may depend on the value of the measured relative humidity. Additionally or as an alternative, a more complex reaction-diffusion model may be implemented, e.g., to describe the usage of water to corrode the metal film, or being permanently bound to the organic ("plastic") material in the housing, and in this way being representative of the damage. The output of the model may be a function that describes and/or summarizes the spatial distribution of moisture inside the energy storage device.

For solving the model, a computational unit may be useful or required, which may be connected to a cloud and may require a means of communication, e.g. a LAN or any other kind of connection. The unit may take the measurements of temperature and relative humidity as input and access a memory unit where a solution of the model, e.g. applied to one or more previous time steps, is stored.

Based on this, the solution of the model - which is the distribution of moisture within the medium - may be converted into a consumed lifetime. In some embodiments, the consumed lifetime may be stored as one single variable, which may be updated with each computation. Storing one single variable is a highly efficient way to deal with the computational results. This conversion function may be chosen in a way that takes into account both the moisture concentration (in the medium or used to corrode some material) as well as its spatial distribution inside the energy storage device. For example, the conversion makes use of the amount of water present in the energy storage device and how much has already reached the inner part with the metallic film. This moisture concentration may then be related to a reference value, corresponding to how much moisture can reach the inner region before the energy storage device reaches end of life. Taking the ratio of the two, the consumed life will be equal to one, when amount of moisture value reaches the reference value. Values larger than one may be reached depending on the definition used to indicate a device at high risk of failing and/or depending on the requirements.

For a deeper insight, a concrete example is provided. The example is based on a one-dimensional diffusion equation

$$\frac{\partial C}{\partial t} = D \frac{\partial^2 C}{\partial x^2} \qquad \text{(Eq. 1)}$$

In the simplest version, the domain for the equation can be taken to be semi-infinite. The boundary condition at x=0, corresponding to the interface to the outside environment, may be obtained from the (ambient) measurement of the relative humidity converted to the one at the surface and inside the capacitor, for example via the Antoine equation to correct for the different temperatures. The diffusion constant D depends on temperature via an Arrhenius law, whose parameters depend on the material properties of the packaging or housing material, which can be determined up front and used in the model.

The equation can be solved for a concentration C(x,t), as well known in the respective literature using a suitable time integration scheme and discretizing the spatial domain accordingly. Other methods, e.g. based on the Greens function may be used as well.

The conversion to a consumed life, can be obtained by integrating the solution C(x,t) from a certain position, e.g. x=1 (mimicking the boundary with the metallic film region) to infinity. Consumed life will be then the ratio between the result of this integral and a reference value.

Please note, that this model contains only a small number of parameters, which allow to set them based on experimental results, e.g. using constant or step-wise constant conditions. In this way, the parameters are not necessarily identical to physical properties, but are reflecting the observed lifetime under these conditions, e.g. from ALT (Accelerated Life Time) tests.

In an optional step, the consumed life can be transformed further: The total amount of moisture within a certain region may not the linearly depending on the consumed life per se. But by running the simulation for constant reference conditions, a reference curve of the total amount of moisture in relation to the consumed life can be calculated. Inverting this curve and using the quantity derived from the model under variable conditions within it, leads to a consumed life value, which under constant conditions will be linear and therefore easier to interpret.

In some embodiments, the result "currently consumed lifetime" may be considered as one single variable, which is taken as a basis for the following computations. This may advantageously save some storage space, because it may be possible to save only this variable in a persistent memory - e.g. in a long-term persistent memory and/or in a special register of the system the energy storage device(s) are placed in - and to use the time-series of measurements of temperature and relative humidity only for the computation. After said computation, the time-series may be deleted.

In some embodiments, each measurement of the time-series is performed on demand and/or periodically, with a period of one minute, one hour, or one day. The frequency of the measurements may depend on the system the energy storage device is arranged in. For instance, measurements in a portable system (e.g. a laptop) may be performed more frequently than in an air-conditioned system (e.g. a server).

In some embodiments, the time-series of measurements is stored for one week, one month, or one year.

In some embodiments, the energy storage device is an accumulator. Examples may comprise types like a Li-Ion (lithium-ion), like LTO (lithium titanat), LMO (manganese), LiFP (lithium iron phosphate), nickel based, like NiMH (Nickel Metal Hydride) or NiCd (nickel-cadmium) accumulator. Generally, the method and the models described above and/or below may be applied to any accumulator, whose lifetime is determined and/or influenced by an amount of water that has diffused into the accumulator.

In some embodiments, the energy storage device is a capacitor, particularly a film capacitor, the film comprising polypropylene (PP), polyethylene terephthalate (PET), polyethylene naphthalate (PEN), polyphenylene sulfide (PPS), polycarbonate (PC), functionally enhanced subvariants including nanostructured materials, another polymer, and/or a combination of these materials. For example, a polymer film type capacitor may serve as a filter capacitor, with a capacity between 1 $\mu$F and 5000 $\mu$F, particularly between 10 $\mu$F and 100 $\mu$F, and specified for a voltage between 100 V and 3000 V, e.g. for 350 V AC. Such a capacitor may have an edge length between 10 mm and 500 mm, particularly between 20 mm and 60 mm. The capacitor types may include electrolyte capacitor types.

In some embodiments, the capacitor comprises at least one internal barrier. Said internal barrier may be implemented, e.g., as a thin layer or as a thicker, i.e. a more extended, zone. The internal barrier may, e.g., be of epoxy resin or any other humidity resistant polymer, alternatively thin metal or other material layers, which have a higher moisture-diffusion blocking behaviour than the main filling material. The internal barrier may slow down the moisture ingress, thus prolonging the lifetime of the energy storage device. The diffusion model may incorporate the effect of the one or more internal barriers and/or the effect of chemical reactions of the water with the metal and/or other materials of the internal barrier in the energy storage device.

An aspect relates to a non-transitory computer-readable storage medium having a program stored therein, which, when executed on a computing unit, instructs the computing unit to perform the method as described above and/or below.

An aspect relates to an apparatus for estimating a consumed lifetime of an energy storage device. The apparatus comprises a humidity sensor configured for measuring an environmental relative humidity of the energy storage device; a temperature sensor configured for measuring a temperature of the energy storage device; a memory configured for storing a time-series of humidity and temperature measurements of the energy storage device and/or an amount of water present in an inner part of the energy storage device; and a computing unit configured for estimating and, optionally, storing values that estimate a consumed lifetime of the energy storage device according to a method as described above and/or below.

The temperature sensor may be arranged on a surface of the energy storage device, and/or inside the device that contains the energy storage device. In some embodiments, only one temperature sensor may be used for determining the temperature of a plurality of energy storage devices.

An aspect relates to a use of an apparatus described above and/or below for estimating a consumed lifetime of an energy storage device.

It should be noted that two or more embodiments described above and/or below can be combined, as far as technically feasible.

For further clarification, the invention is described by means of embodiments shown in the figures. These embodiments are to be considered as examples only, but not as limiting.

Brief Description of the Drawings

The drawings depict:

| | |
|---|---|
| **Figs. 1a, 1b, 1c** | schematically an energy storage device according to an embodiment; |
| **Figs. 2a, 2b, 2c** | schematically an energy storage device according to an embodiment; |
| **Figs. 3a, 3b** | solutions of a diffusion model according to an embodiment; |
| **Fig. 4** | example of a consumed lifetime of an energy storage device according to an embodiment; |
| **Fig. 5** | a flow diagram according to an embodiment. |

Detailed Description of Embodiments

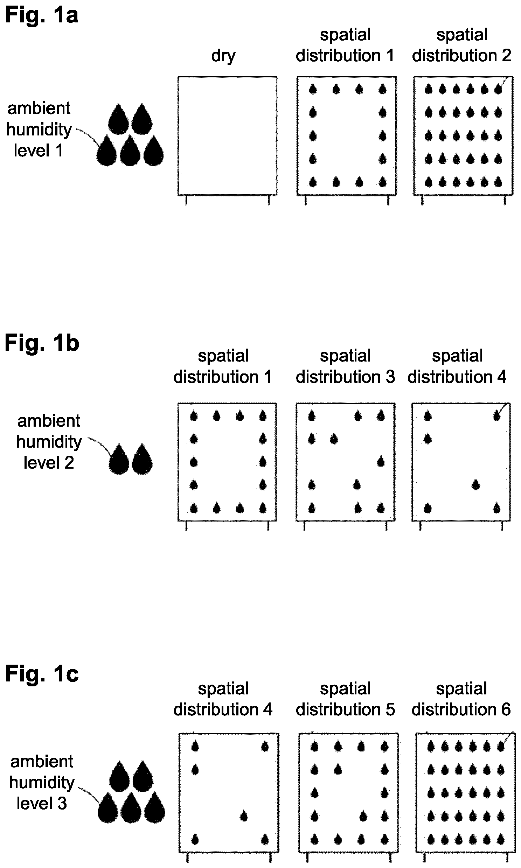

**Figs. 1a, 1b, 1c** show schematically an energy storage device according to an embodiment. In the figures, a capacitor is taken as an example, but the information may easily be applied to other types of energy storage devices as well. The figures shall depict, how the moisture concentration inside the capacitor (depicted as a rectangular) may - at least under some circumstances - be partially reversible. The waterdrops inside the frames show schematically a level of moisture concentration inside the capacitor, as well as their spatial distribution over time. **Fig. 1 a left** shows a kind of starting point, with a "dry" capacitor, i.e. a capacitor that still has no water inside, e.g. a new capacitor. After being exposed to a high ambient relative humidity level ("level 1", shown by 5 drops, left hand), the water will first accumulate through the outer region, showing already some water ingress, but not yet a damage of the capacitor, as the water has still not reached the core; see **Fig. 1a mid,** which shows an intermediate moisture distribution ("spatial distribution 1"), i.e. an increased moisture level close to the capacitor's borders. After further (e.g. long) exposure to "ambient humidity level 1", the water may have reached also the inner parts; see **Fig. 1a right,** which shows a high moisture concentration ("spatial distribution 2"), almost equally distributed inside the capacitor. With "spatial distribution 2", the capacitor will be damaged, and the estimated consumed lifetime will be 100 %, then.

**Fig. 1b** shows an effect of a change to a low ambient relative humidity level ("level 2", shown by 2 drops). This may lead to a "reversal" of estimated consumed lifetime. Starting with "spatial distribution 1" (cf.

**Fig. 1a mid** and **Fig. 1b left),** i.e. the capacitor was exposed to some high humidity at an initial stage. Then, the capacitor may have been moved to a site with "ambient humidity level 2", i.e. with a quite low ambient relative humidity level and/or countermeasures may have been taken, e.g. by introducing the capacitor to a dryer. The resulting effect ("spatial distribution 3"), as shown in **Fig. 1b mid,** may be twofold: On the one hand, the penetration of water continues, i.e. some water will reach the inner parts; on the other hand, the amount of water is reduced, leading to a decrease of the estimated consumed lifetime. Being further exposed to "ambient humidity level 2", the decrease of the estimated consumed lifetime continues, leading to "spatial distribution 4"; see **Fig. 1b right.** In this example, finally the moisture has reached the inner part, but with a much lower humidity level and leading to a reduction of the estimated consumed lifetime. **Fig. 1b** shows clearly, that the history of exposure may be important and that a removal of moisture makes the lifetime reversible.

**Fig. 1c** shows an effect of an again-increasing ambient relative humidity level on the spatial distribution of the moisture inside the capacitor, i.e. slowly increasing the moisture concentration with time. In this example, the capacitor is exposed to a high ambient relative humidity level ("level 3", shown by 5 drops, comparable to "level 1"). Starting with "spatial distribution 1" (cf. **Fig. 1b right** and **Fig. 1c left),** i.e. the capacitor was exposed to "level 3". As a consequence, "spatial distribution 5" (see **Fig. 1c mid)** occurs: The water in the capacitor's inner parts firstly stays the same, but the water in the outer regions increases. Though this effect is not immediate, the moisture will first stay in the outer region before a further increase finally leads to a damage of the capacitor; see "spatial distribution 6", **Fig. 1c right**, which is similar to "spatial distribution 2" of **Fig. 1a right.**

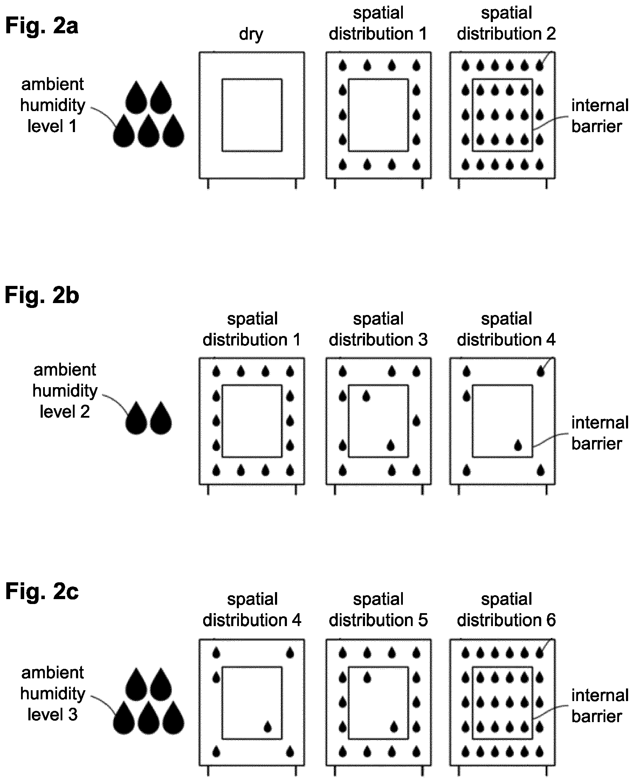

**Figs. 2a, 2b, 2c** show schematically an energy storage device according to an embodiment. The energy storage devices of these figures have an additional internal barrier. The scenarios of increasing and decreasing ambient relative humidity are similar to the ones of **Figs. 1a, 1b, 1c.** It can clearly be seen that these devices also have an increasing and decreasing moisture content inside the device, depending on the ambient relative humidity level. However, in **Fig. 2a,** the time coming from "dry" **(Fig. 2a left)** to "spatial distribution 1" (see **Fig. 2a mid)** is much longer than for capacitors without the internal barrier. The same applies for the time from "spatial distribution 1" to "spatial distribution 2" **(Fig. 2a right).** As a result, the high outside humidity "level 1" firstly leads to an accumulation in the outer layers (here shown up to the barrier). Thus, the barrier is meant to block or at least delay the further progression of the content into the inner parts for some time. This effect applies analogously to **Figs. 2b** and **2c.** Accordingly, **Figs. 2a, 2b, 2c** explain why it is advantageous to consider the additional internal barrier inside the capacitor.

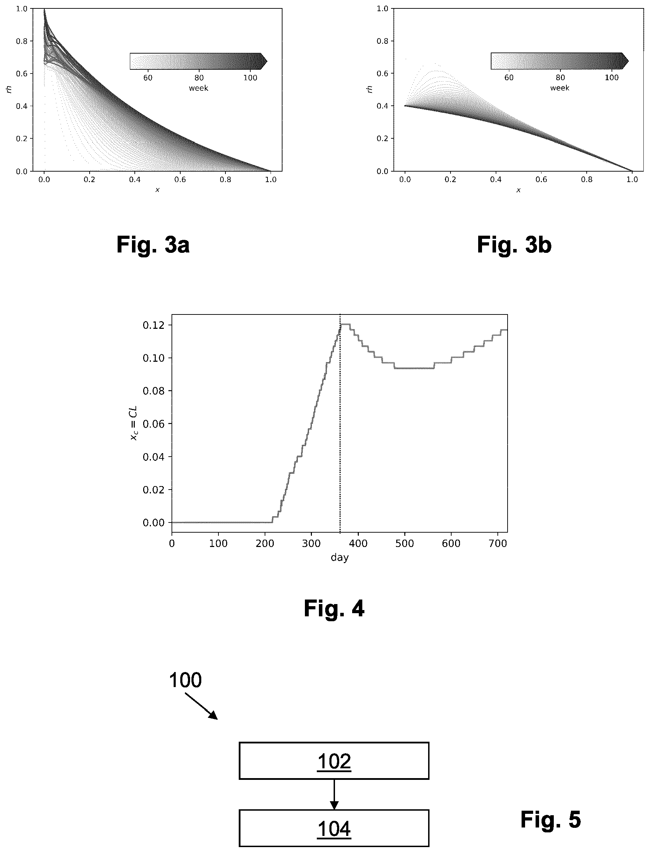

**Figs. 3a, 3b** show solutions of a diffusion model according to an embodiment. The x-axis shows a position x within the device. The y-axis shows the water density or concentration rh ("relative humidity", i.e. relative to the saturation density in the surrounding air; hence, this is usually normalized to it). **Fig. 3a** shows a solution of a quite realistic version of the diffusion model after one year of exposure using some real meteorological conditions (e.g. of Singapore). The curves are plotted for each week and their progression is reflected in the increased darkness for later times. **Fig. 3b** shows a solution after an additional year with constant conditions T = 20 °C and external relative humidity = 0.4. These figures show in general a humidity or water distribution inside the energy storage device, or the model of it, which can be quite complex and depending on the history of humidity and temperature.

**Fig. 4** shows an example of a consumed lifetime of an energy storage device according to an embodiment. The y-axis shows a value representative of the progress of water in the model, where the distance from the inside and where the total amount of content reaches a critical amount. This may be used as a basis for estimating the consumed life $x_c$ = CL. The x-axis shows a time of exposure of the energy storage device to two different ambient relative humidity levels applied to the energy storage device for two different time spans. A dotted line separates the two halves of this time span. The first half of this time span, the energy storage device is placed in a high ambient relative humidity level (about the "5 drops" moisture level of, e.g., **Fig. 1a).** The second half of this time span, the energy storage device is placed in a low ambient relative humidity level (about the "2 drops" moisture level of, e.g., **Fig. 1b).** This leads to the effect that firstly - say: until 200 days - the internal moisture, inside the device, is still low enough for not reaching a critical value. This is followed by a nearly linear increase. When placed to the low ambient relative humidity level, the internal moisture still increases for a couple of days, before a decrease sets in. After some time, due to the further diffusion into the device, this reduction is again reverted.

**Fig. 5** shows a flow diagram 100 according to an embodiment, reflecting a method for estimating a consumed lifetime of an energy storage device. In a step 102, a time-series of an environmental relative humidity and a related temperature of the energy storage device is measured. In a step 104, the consumed lifetime of the energy storage device is estimated. based on the time-series and on a moisture diffusion model of the energy storage device.

**Claims**

1.  A method for estimating a consumed lifetime of an energy storage device, the method comprising the steps of:

measuring a time-series of an environmental relative humidity and a related temperature of the energy storage device; and
estimating, based on the time-series and on a moisture diffusion model of the energy storage device, the consumed lifetime of the energy storage device.

2. The method of claim 1,
wherein the moisture diffusion model considers a spatial distribution of moisture inside the energy storage device.

3. The method of claim 1 or 2,
wherein the moisture diffusion model considers a diffusion of moisture into and inside the energy storage device.

4. The method of any one of the preceding claims,

wherein the moisture diffusion model considers a temperature inside the energy storage device, and/or
the moisture diffusion model estimates the temperature inside the energy storage device, and/or
the parameters of the moisture diffusion model are obtained by doing aging tests for specific conditions.

5. The method of any one of the preceding claims,
wherein the consumed lifetime is a function of an amount of water present in an inner part of the energy storage device.

6. The method of any one of the preceding claims,
wherein the consumed lifetime and/or the amount of water is stored as one single variable or distribution function.

7. The method of claim 6,
wherein the distribution function is based on a 3D, 2D or 1D model of the energy storage device.

8. The method of any one of the preceding claims,

wherein each measurement of the time-series is performed on demand and/or periodically, with a period of one minute, one hour, or one day.

9. The method of any one of the preceding claims,
wherein the time-series of measurements is stored for one week, one month, or one year.

10. The method of any one of the preceding claims,
wherein the energy storage device (10) is a capacitor, particularly a film capacitor, the film comprising polypropylene (PP), polyethylene terephthalate (PET), polyethylene naphthalate (PEN), polyphenylene sulfide (PPS), polycarbonate (PC), functionally enhanced subvariants including nanostructured materials, another polymer, and/or a combination of these materials.

11. The method of claim 10,
wherein the capacitor comprises at least one internal barrier.

12. A non-transitory computer-readable storage medium having a program stored therein, which, when executed on a computing unit, instructs the computing unit to perform the method according to any one of the preceding claims.

13. An apparatus for estimating a consumed lifetime of an energy storage device, the apparatus comprising:

a humidity sensor configured for measuring an environmental relative humidity of the energy storage device;
a temperature sensor configured for measuring a temperature of the energy storage device;
a memory configured for storing a time-series of humidity and temperature measurements of the energy storage device and/or an amount of water present in an inner part of the energy storage device; and
a computing unit configured for estimating and, optionally, storing values that estimate a consumed lifetime of the energy storage device according to a method of any one of the preceding claims.

14. Use of an apparatus according to claim 13 for estimating a consumed lifetime of an energy storage device.

## Fig. 1a

## Fig. 1b

## Fig. 1c

**Fig. 2a**

**Fig. 2b**

**Fig. 2c**

**Fig. 3a**

**Fig. 3b**

**Fig. 4**

**Fig. 5**

Europäisches
Patentamt
European
Patent Office
Office européen
des brevets

# EUROPEAN SEARCH REPORT

**Application Number**

EP 23 18 4969

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 113 311 265 A (UNIV HUAZHONG SCIENCE TECH) 27 August 2021 (2021-08-27) | 1,4-14 | INV. G01R31/392 H01G4/33 |
| A | * abstract; figures 1-2 * | 2 | |
| X | CN 111 104 756 A (UNIV XI AN JIAOTONG) 5 May 2020 (2020-05-05) | 1,3-14 | |
| A | * abstract; figures 1-3 * | 2 | |
| X | CN 110 580 382 A (UNIV HUAZHONG SCIENCE TECH) 17 December 2019 (2019-12-17) | 1,3-14 | |
| A | * abstract; figure 1 * | 2 | |
| A | US 2018/372802 A1 (PETRUCELLI STEVEN [US]) 27 December 2018 (2018-12-27) * the whole document * | 1-14 | |

TECHNICAL FIELDS
SEARCHED     (IPC)

G01R
H01G

The present search report has been drawn up for all claims

| Place of search | Date of completion of the search | Examiner |
|---|---|---|
| Munich | 12 December 2023 | Brune, Markus |

EPO FORM 1503 03.82 (P04C01)

## ANNEX TO THE EUROPEAN SEARCH REPORT
## ON EUROPEAN PATENT APPLICATION NO.

**EP 23 18 4969**

This annex lists the patent family members relating to the patent documents cited in the above-mentioned European search report.
The members are as contained in the European Patent Office EDP file on
The European Patent Office is in no way liable for these particulars which are merely given for the purpose of information.

**12-12-2023**

| Patent document cited in search report | | Publication date | Patent family member(s) | | Publication date |
|---|---|---|---|---|---|
| CN 113311265 | A | 27-08-2021 | NONE | | |
| CN 111104756 | A | 05-05-2020 | NONE | | |
| CN 110580382 | A | 17-12-2019 | NONE | | |
| US 2018372802 | A1 | 27-12-2018 | US | 2016077159 A1 | 17-03-2016 |
| | | | US | 2017356963 A1 | 14-12-2017 |
| | | | US | 2018372802 A1 | 27-12-2018 |
| | | | WO | 2016040823 A1 | 17-03-2016 |

EPO FORM P0459

For more details about this annex : see Official Journal of the European Patent Office, No. 12/82